# EUROPEAN PATENT APPLICATION

(11) **EP 2 039 727 A1**
(43) Date of publication of application: **25.03.2009**
(21) Application number: 07116658.1
(22) Date of filing: 18.09.2007
(51) Int. Cl.: C09B 67/04, G03F 7/00, C09B 67/12, C09B 67/22, C09B 67/50

(54) **Preparation of epsilon copper phthalocyanine of small primary particle size and narrow particle size distribution**

(71) Applicant: SOLVAY (Société Anonyme), 1050 Bruxelles (BE)
(72) Inventor: Jung, KiSuck, Pusan (KR); Jeong, Eun-Ha, Ulsan (KR); Han, Sang-Min, Pusan (KR); Kim, Dong-Yoon, Ulsan (KR); Jeong, Hyun-Seok, Pusan (KR); Choi, Il-Jo, Pusan (KR)
(74) Representative: Vande Gucht, Anne

(57) **Abstract**

A process of preparing copper phthalocyanine particles exhibiting a ε crystallographic form, comprising a heating step by heating at a temperature higher than or equal to 50°C copper phthalocyanine particles with more than 80 wt % of the particles exhibiting an α crystallographic form and less than 20 wt % of particles exhibiting an ε crystallographic form in the presence of a first organic liquid and optionally milling in the presence of beads.

## Description

### Technical field

The present invention relates to a process of preparing epsilon crystal form copper phthalocyanine (ε-CuPc) particles of small particle size and narrow particle size distribution, epsilon crystal form copper phthalocyanine particles obtainable according to said process and the use of the same for the preparation of blue filters pigments for the fabrication of liquid crystal display (LCD) devices.

### Background art

Among all pigments, copper phthalocyanine is especially stable and is excellent in terms of a variety of fastness. Further, the copper phthalocyanine has many crystal forms. Of these crystal forms, those known to have already found their actual use include alpha, beta and epsilon crystal forms of copper phthalocyanine. It is a common practice to use the beta crystal form to impart a greenish blue colour and the alpha crystal form to impart a reddish blue colour. However, the epsilon crystal form is employed when the impartation of a blue colour, which is more reddish than that available from the use of the alpha crystal form, is required.

The epsilon crystal form copper phthalocyanine has a reddish hue, a high clearness and a high tinting strength compared to the alpha crystal form. In addition, their solvent resistance against the crystal growth of primary crystals is higher than that of the beta crystal form. Further, their solvent resistance against the crystal transformation into the beta crystal form is higher than that of other polymorph copper phthalocyanines. Therefore, the epsilon crystal form copper phthalocyanine is a molecular aggregate having a crystal form, which has remarkably excellent properties with less apprehension about a change of hue and a decrease in tinting strength and clearness. Also, the thermodynamic stability of the epsilon crystal form is next to that of the beta crystal form, which is the most stable crystal form among polymorph crystals.

It has repeatedly been disclosed that copper phthalocyanine (crystallographically crude or in the pure alpha crystallographic phase) is easily convertible into its beta crystal form, e.g., by salt grinding with a solvent, dry grinding in the presence or absence of a salt followed by solvent treatment, dry grinding with a solid binder in an inert atmosphere, or dry or aqueous grinding followed by conditioning.

Further, the typical process for the production of epsilon crystal form copper phthalocyanine is the solvent salt milling process. In such a process, copper phthalocyanine particles having a crystal other than the epsilon crystal form and copper phthalocyanine particles having epsilon crystal form are milled in an organic solvent in the presence of beads by means of a strong mechanical force for a long time.

US 2005215780 describes a process for the production of epsilon crystal form copper phthalocyanine. Such a process comprises heat-treating copper phthalocyanine in a solvent at a temperature ranging from 80°C to 250°C in the presence of a Lewis acid.

JP 2005234009 discloses a blue pigment composition for a colour filter containing epsilon crystal form copper phthalocyanine fine pigment having 0.01 to 0.06 µm average particle diameter of primary particles (measured by a transmission electron microscope). It also discloses a method of manufacturing the same by salt milling. Said epsilon crystal form copper phthalocyanine fine pigment contains a sulfonic acid amide derivative of copper phthalocyanine, a phthalimidemethyl derivative of copper phthalocyanine and a derivative containing a sulfonic acid or its salt of phthalocyanine.

JP 2004244563 describes a method of producing epsilon crystal form copper phthalocyanine pigment, wherein the pigment particles are micronized and sized comparable to the solvent salt milling method. In said method, crude epsilon crystal form copper phthalocyanine pigment with a greater average particle diameter than 100 nm is added to pre-pigment with an average particle diameter of 10-100 nm. The mixture is subjected to dry grinding by adding a small amount of an organic solvent. Particle size regulation is performed by suppressing a change of average particle diameter of the ε-CuPc pigment to 30 nm or less.

JP 2002121420 discloses a process of manufacturing epsilon crystal form copper phthalocyanine fine pigment. This process involves milling crude epsilon crystal form copper phthalocyanine in the presence of an organic solvent and a mineral salt. Such manufactured epsilon crystal form copper phthalocyanine fine pigment has BET specific surface area of 95-150 m²/g in a nitrogen absorption process. Further, it exhibits excellent dispersibility and lightness.

US 2002014183 describes pigmentary solid solutions comprising copper phthalocyanine as a host and other blue to violet pigments as guests, wherein the preferred hosts are the alpha, beta and epsilon crystal forms of copper phthalocyanine. Said method includes a conversion of copper phthalocyanine into epsilon crystal form by kneading with a crystalline inorganic salt or a mixture of crystalline inorganic salts and an organic liquid.

EP 1130065 discloses a conversion of copper phthalocyanine into the epsilon crystal form. It also discloses a manufacture of pigment composition by wet and dry grinding of copper phthalocyanine, another polycyclic pigment and a copper phthalocyanine derivative.

KR 100215919B describes a method of manufacturing epsilon crystal form copper phthalocyanine pigment using a novel copper phthalocyanine derivative. This process comprises adding 5-30 wt % of the copper phthalocyanine derivative with reference to alpha, gamma crystal form copper phthalocyanine or mixture thereof and mechanically kneading the mixture at 50-180°C to restrict crystal conversion into beta copper phthalocyanine and derive stable crystal transition into epsilon crystal form copper phthalocyanine.

JP 4301648 discloses a material containing rod-form epsilon crystal form copper phthalocyanine having 1/4-1/10 in average of the ratio of minor axis (S) to major axis (L). Said epsilon crystal form copper phthalocyanine is obtained by treating a mixture of alpha- and epsilon- crystal form copper phthalocyanines with organic solvent, followed by a dry process.

JP 4252273 describes a method of producing epsilon form copper phthalocyanine, which comprises dry grinding crude epsilon form copper phthalocyanine using a hammer mill, etc., to give a mixture of epsilon and alpha form crystals. It also comprises heat treating the mixture in an organic solvent to provide the objective copper phthalocyanine pigment.

JP 57149358 discloses a production method of epsilon crystal form copper phthalocyanine, which comprises the steps of heating and stirring organic compounds capable of forming phthalocyanine rings, urea, Cu compounds and reaction catalysts. The improvement is that crystalline reforming agents and epsilon crystal form copper phthalocyanine crude pigment as a seed crystal with specific surface areas of less than 35 m²/g are added at the beginning of such synthetic reaction. Said method provides pure copper phthalocyanine in an economic and safe manner.

FR 2278739 describes the use of a stabilizing compound of the formula Pc-(X--A)ₙ, wherein Pc is metallized or unmetallized phthalocyanine radical, X is O, S, or --NH--, and A is 4-20 carbon straight or branched chain alkyl, an unsubstituted aryl, or an aryl substituted by halogen, trifluoromethyl, alkyl, or alkoxy. The modified pigments are shown to improve the stability of unmodified phthalocyanine pigments towards phase transformations.

FR 2174089 describes a method of isolating pure or practically pure epsilon crystal form copper phthalocyanine by grinding alpha, beta and gamma crystal forms in a high energy grinder and treating with a solvent.

However, the foregoing methods of preparing epsilon crystal form copper phthalocyanine of the prior art have problems in that they need too much time for crystal phase conversion and particle size reduction. It has thus been desired to develop a method of effectively preparing epsilon crystal form copper phthalocyanine with reduced time for crystal phase conversion and particle size reduction.

### Disclosure of the invention

It is thus a first object of the invention to provide a process of preparing epsilon crystal form copper phthalocyanine, which comprises a conversion of copper phthalocyanine from alpha crystal form to epsilon crystal form by chemical or milling treatment optionally followed by size reduction of the epsilon crystal form copper phthalocyanine by salt kneading.

Another object of the invention is to provide epsilon crystal form copper phthalocyanine primary particles of small size and narrow particle size distribution obtainable according to said process.

Still yet another object of the invention is to use said epsilon crystal form copper phthalocyanine particles in the preparation of color filter pigments and in the fabrication of liquid crystal display (LCD) devices.

Hereinafter, the present invention is described in detail.

It is the purpose of the present invention to develop copper phthalocyanine (CuPc), which can be effectively used as blue pigment of color filters for LCD. Such filters (e.g., phthalocyanine) must be highly transparent, homogeneous and able to be prepared in a layer with a very uniform thickness. These features are decided by chemical purity, crystallographic purity, primary particle size and particle size distribution of copper phthalocyanine. In this regard, the present invention is directed to developing a new and more efficient process of preparing copper phthalocyanine, which satisfies the above-mentioned features.

The invention is therefore related to a process of preparing copper phthalocyanine particles exhibiting a ε crystallographic form, comprising a heating step by heating at a temperature higher than or equal to 50°C copper phthalocyanine particles with more than 80 wt % (preferably more than 85 wt %, more preferably more than 90 wt %, the most preferably more than 95 wt %) of the particles exhibiting an α crystallographic form and less than 20 wt % (preferably less than 15 wt %, more preferably less than 10 wt %, the most preferably less than 5 wt %) of the particles exhibiting an ε crystallographic form as a seed in the presence of a first organic liquid and optionally milling in the presence of beads.

Milling, as defined herein, means a process by which the solids are subjected to attrition, grinding, etc. to achieve particle size reduction. Dry milling, as defined herein, means a process by which the solids are subjected to attrition, grinding etc. to achieve particle size reduction while substantially free of liquid. However, a low level of solvent may be added.

The process of the present invention is preferably characterized by the following three steps: 1) crystal phase conversion of copper phthalocyanine from beta crystal form to alpha crystal form; 2) crystal phase conversion of copper phthalocyanine from alpha crystal form to epsilon crystal form; and 3) primary particle size reduction of epsilon crystal form copper phthalocyanine.

The averaged primary particle size of copper phthalocyanine finally obtained by the process of the present invention is generally lower than or equal to 30 nm, preferably lower than or equal to 20 nm, which is smaller than those of commercially available products. Since epsilon crystal form copper phthalocyanine having a smaller particle size causes a better contrast of color filter, they can be effectively used as blue filters for LCD devices. The averaged primary particle size can be determined by selecting at least 50 primary particles in the transmission electron microscope (TEM) image which form aggregates and then obtaining an averaged value of their longitudinal diameters.

The copper phthalocyanine particles exhibiting an α crystallographic form used in the process of the invention can be prepared by any process. It is preferred that they are prepared from copper phthalocyanine particles exhibiting a β crystallographic form by using an acid paste method. The beta crystal form copper phthalocyanine is commercially available from various companies such as Toyo Ink (Japan), Dainippon Ink & Chemicals Co. (Japan), etc. The beta crystal form copper phthalocyanine is subjected to crystal phase conversion into alpha crystal form by acid pasting. Acid pasting refers to the dissolution preferably complete of the pigment preferably crude in an acid followed by precipitation. Preference is given to using acids such as sulfuric acid, chlorosulfonic acid and polyphosphoric acid. The precipitation medium, which is employed, generally comprises water, organic solvents or mixtures thereof. Precipitation takes place preferably under turbulent flow conditions. Such a treatment is described for instance in Ullmann's Encyclopedia of Industrial Chemistry, Fifth Completely Revised Edition, 1992, Volume A20, pp. 225-226.

In step 2, the alpha crystal form copper phthalocyanine is subjected to crystal phase conversion into epsilon crystal form by chemical or milling treatment.

In the process of the invention, the alpha crystal form copper phthalocyanine is treated at a temperature higher than or equal to 50°C, preferably higher than or equal to 75°C, more preferably higher than or equal to 100°C, yet more preferably higher than or equal to 125°C, and most preferably higher than or equal to 150°C. The temperature of the heating step is generally lower than or equal to 210°C, preferably lower than or equal to 200°C, more preferably lower than or equal to 190°C, yet more preferably lower than or equal to 180°C, and most preferably lower than or equal to 170°C. When the temperature is lower than 50°C, the conversion from the alpha crystal form into the epsilon crystal form does not occur. When the temperature is higher than 210°C, disadvantageously as a pigment, primary crystals grow and the thermal energy tends to be wasted.

In the process according to the invention, the duration of the heating step is generally higher than or equal to 0.5 h, more preferably higher than or equal to 1 h, yet more preferably higher than or equal to 2 h, and most preferably higher than or equal to 3 h. That duration is generally lower than or equal to 12 h, preferably lower than or equal to 10 h, more preferably lower than or equal to 8 h, yet more preferably lower than or equal to 6 h, and most preferably lower than or equal to 4 h.

In the process of the invention, the heating step is carried out in the presence of a first organic liquid. The first organic liquid suitable for the use in the present invention may include, but is not limited to, N-methyl-2-pyrrolidone, sulfolane, N,N-dimethyl formamide, glycols and glycols derivatives such as propylene glycol monomethyl ether acetate, diethylene glycol, alcohols such as diacetone alcohol, acetonitrile, monochlorobenzene, ethylene glycol butyl ether, ketones and quinolines, preferably N-methyl-2-pyrrolidone and any mixture of at least two of them. The first organic liquid may further comprise water.

In the process according to the invention, the heating step can be carried out under agitation or in the absence of agitation. It is preferred to carry it out under agitation.

The proportion of the first organic liquid used in the present invention to the alpha crystal form copper phthalocyanine by weight ratio is generally higher than or equal to 0.033 and preferably higher than or equal to 0.05. That ratio is usually lower than or equal to 0.2 and more preferably lower than or equal to 0.1.

In the process according to the invention, the heating step optionally comprises milling in the presence of beads.

In such embodiment, the alpha crystal form copper phthalocyanine is treated at a temperature higher than or equal to 50°C, preferably higher than or equal to 60°C, more preferably higher than or equal to 70°C, and most preferably higher than or equal to 80°C. The temperature of the heating step is generally lower than or equal to 210°C, preferably lower than or equal to 180°C, more preferably lower than or equal to 150°C, yet more preferably lower than or equal to 120°C, and most preferably lower than or equal to 100°C.

In such embodiment, the duration of the heating step is generally higher than or equal to 0.5 h, more preferably higher than or equal to 1 h, yet more preferably higher than or equal to 2 h, and most preferably higher than or equal to 3 h. That duration is generally lower than or equal to 12 h, preferably lower than or equal to 10 h, more preferably lower than or equal to 6 h, and most preferably lower than or equal to 4 h.

In such embodiment, the heating step is carried out in the presence of a first organic liquid. The first organic liquid suitable for the use in the present invention may include, but is not limited to, N-methyl-2-pyrrolidone, sulfolane, N,N-dimethyl formamide, glycols such as propylene glycol monomethyl ether acetate, diethylene glycol, alcohols such as diacetone alcohol, acetonitrile, monochlorobenzene, ethylene glycol butyl ether, ketones and quinolines, preferably N-methyl-2-pyrrolidone. The first organic liquid may further comprise water.

In such embodiment, the proportion of the amount of the first organic liquid used in the present invention to the amount of the alpha crystal form copper phthalocyanine by weight ratio is as defined hereabove on page 7, lines 6 to 9.

The beads suitable for the use in the present invention as a milling media may include, but is not limited to, metallic beads, plastic beads, inorganic oxide beads such as zirconia and glass beads, preferably zirconia beads. The proportion of the beads used in the present invention to the alpha crystal form copper phthalocyanine by weight ratio is generally higher than or equal to 0.01 and preferably higher than or equal to 0.166. That proportion is usually lower than or equal to 0.5 and more preferably lower than or equal to 0.333.

Through the heating treatment described above, the alpha crystal form copper phthalocyanine can be effectively converted into the epsilon crystal form having a narrow particle size distribution, which was determined from D₁₀ and D₉₀ percentiles measured by a Particle Size Analyzer.

The process according to the invention may further comprise the following steps :
a) a separation step by separating the copper phthalocyanine particles exhibiting a ε crystallographic form from the first organic liquid and optionally from the beads;
b) a kneading step by kneading the copper phthalocyanine particles separated at step a) with at least one inorganic salt and a second organic liquid; and
c) a recovery step by recovering the copper phthalocyanine particles by removing the second organic liquid and the inorganic salt.

The separation step can be carried out by any means, for instance filtration using any appropriate filter, decantation, centrifugation, etc. Preferably, filtration can be used to separate the copper phthalocyanine particles exhibiting a ε crystallographic form.

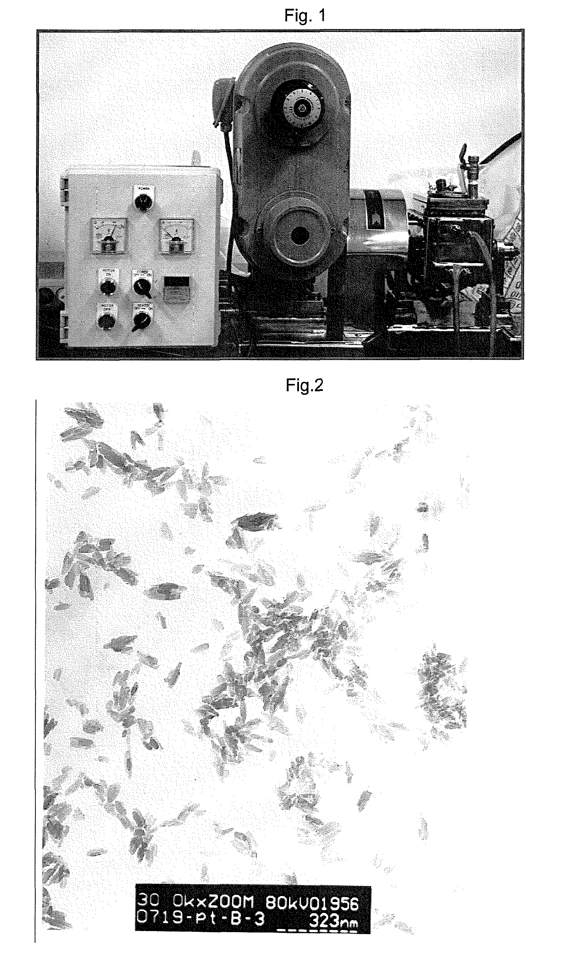

In order to reduce the primary particle size of the epsilon crystal form copper phthalocyanine converted above, the step of kneading the same with salt is conducted in the presence of at least a second organic liquid. For the preferred salt kneading process, it is possible to use a typical continuous kneading unit well known in the art including a single kneading-screw type and a twin kneading-screw type. In a preferred embodiment, the present invention employs a salt-kneading system as illustrated in Fig. 1.

The kneading step is carried out for a duration which is generally higher than or equal to 2 h, preferably higher than or equal to 3 h, more preferably higher than or equal to 5 h and most preferably higher than or equal to 6 h. That duration is generally lower than or equal to 36 h, preferably lower than or equal to 18 h, more preferably lower than or equal to 12 h and most preferably lower than or equal to 8 h.

The kneading step is carried out at a temperature which is generally higher than or equal to 0°C and preferably higher than or equal to 10°C and most preferably higher than or equal to 50°C. That temperature is generally lower than or equal to 130°C, preferably lower than or equal to 80°C and more preferably lower than or equal to 60°C.

The second organic liquid suitable for the kneading step may include, but is not limited to, N-methyl-2-pyrrolidone, sulfolane, N,N-dimethyl formamide, diethylene glycol, N-methyl formamide, diacetone alcohol, glycerin, ethylene glycol, propylene glycol, polypropylene glycol, 2-butoxy ethanol, triethylene glycol, diethylene glycol monomethyl ether, triethylene glycol monomethyl ether, dipropylene glycol monomethyl ether, 1-methoxy-2-propanol,1-ethoxy-2-propanol, ketones, quinolines, and any mixture of at least two of them, and the second organic liquid is preferably N-methyl-2-pyrrolidone. The second organic liquid may further comprise water.

In the kneading step, the proportion of the second organic liquid to the epsilon crystal form copper phthalocyanine by weight ratio is generally higher than or equal to 0.033 and more preferably higher than or equal to 0.050. That proportion is generally lower than or equal to 1.0 and more preferably lower than or equal to 0.666.

In the kneading step of the process according to the present invention, the inorganic salt suitable for the salt kneading process may include, but is not limited to, aluminum sulfate, sodium sulfate, calcium chloride, potassium chloride or sodium chloride, preferably sodium chloride which may if desired and available contain water of crystallization. The proportion of the inorganic salt to the epsilon crystal form copper phthalocyanine by weight ratio is generally higher than or equal to 0.067 and preferably higher than or equal to 0.1. That proportion is generally lower than or equal to 1.0 and more preferably lower than or equal to 0.2.

The inorganic salt has an average particle size which is generally higher than or equal to 0.3 µm. That average particle size is generally lower than or equal to 200 µm, preferably lower than or equal to 50 µm, which was measured by a Particle Size Analyzer. The inorganic salt is generally soluble in water, preferably to the extent of at least 10 g/100 ml of water.

The rotary speed of the salt kneading system used in the present invention should be adjusted, taking into account the cooling if necessary, in such a way that the kneaded composition is moved homogeneously under uniform share. It is preferable to maintain the rotary speed during the salt kneading to the range from 30 to 150 rpm, more preferably from 50 to 120 rpm.

After the kneading step c), the copper phthalocyanine particles are recovered by removing the inorganic salt and the second organic liquid. The removal can be done by any means. It is preferred that it is done by washing the inorganic salt and the second organic liquid away with water, especially with demineralized water.

The process according to the invention may comprise a further drying step after step c). The drying step is conducted preferably at a temperature higher than or equal to -20°C and lower than or equal to 250°C for a pressure higher than or equal to 10⁻¹ Pa and lower than or equal to 10⁵ Pa, with very particular preference at a temperature around 80°C and for a pressure around 10⁴ Pa.

In order to increase dispersability of the resultant copper phthalocyanine particles exhibiting a ε crystallographic form, particles of copper phthalocyanine substituted by a functional group (dispersion aid) may be further added during the acid pasting step and/or the heating step optionally in the presence of beads and/or during the kneading step b) of the process according to the invention. In addition, the process of the present invention may further comprise the step of dry-blending, wherein particles of copper phthalocyanine substituted by a functional group are further blended after the recovery step c).

The particles of copper phthalocyanine used as a dispersion aid in the present invention may be substituted by at least one functional group selected from -SO₃M, -SO₂NR₁R₂ and -R₃-NR₄R₅, wherein: R₁ and R₂ are independent of one another and are hydrogen, alkyl, alkenyl, aryl or cycloalkyl; M is proton, ammonium cation or metal cation; R₃ is single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N=N-.

More preferably, the particles of copper phthalocyanine may be substituted by the functional group of -SO₃H, -SO₂NHR₁ , wherein R₁ is hydrogen, alkyl, alkenyl, aryl, cycloalkyl or

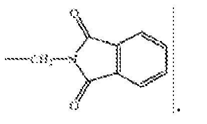

In a preferred embodiment, the process according to the invention comprises the following steps :
1) preparing copper phthalocyanine particles with more than 80 wt % of the particles exhibiting an α crystallographic form from copper phthalocyanine particles exhibiting a β crystallographic form by using an acid paste method
2) a heating step by heating at a temperature higher than or equal to 50°C the copper phthalocyanine particles with more than 80 wt % of the particles exhibiting an α crystallographic form of step 1) and less than 20 wt % of the particles exhibiting an ε crystallographic form in the presence of a first organic liquid and optionally milling in the presence of beads
3) separating the copper phthalocyanine particles exhibiting a ε crystallographic form from the first organic liquid and optionally the beads;
4) kneading the copper phthalocyanine particles separated at step a) with at least one inorganic salt and a second organic liquid; and
5) recovering the copper phthalocyanine particles by removing the second organic liquid and the inorganic salt.

In spite of reducing the kneading time compared to the existing method in the art, the process of the present invention can obtain epsilon crystal form copper phthalocyanine having a smaller averaged primary particle size, a narrower size distribution and a better primary particle shape.

The average primary particle size is generally lower than or equal to 30 nm, preferably lower than or equal to 20 nm.

The particle size distribution (PSD) is measured by a Particle Size Analyzer (PSA). The narrowness of the particle size distribution is characterized from D₁₀ and D₉₀ values measured by the PSA.

The primary particle shape of the CuPc particles is preferably a spherical shape, when observed by their TEM image.

It is believed that one embodiment of the present invention provides combination of the chemical or milling treatment and kneading steps, by which CuPc particles exhibiting α-crystallographic form is converted to ε-crystallographic form easily and crystal purity is also improved, and further the process reduces the time for crystal phase conversion and particle size reduction.

The present invention provides a process of preparing epsilon crystal form copper phthalocyanine particles, comprising a heating step by heating at a temperature of higher than equal to 50°C copper phthalocyanine particles with more than 80 wt % of the particles exhibiting an alpha crystal form and less than 20 wt % of the particles exhibiting an epsilon crystal form in the presence of a first organic liquid and optionally milling in the presence of beads.

The process of the present invention may further comprise the following steps :
a) a separation step by separating the epsilon crystal form copper phthalocyanine particles from the first organic liquid and the beads, if used;
b) a kneading step by kneading the copper phthalocyanine particles separated at step a) with at least one inorganic salt and a second organic liquid to obtain the copper phthalocyanine particles having an averaged particle size of less than 30 nm; and
c) a recovery step by recovering the copper phthalocyanine particles by removing the second organic liquid and the inorganic salt.

In the process of the present invention, the copper phthalocyanine particles with more than 80 wt % of the particles exhibiting an alpha crystal form may be prepared from copper phthalocyanine particles exhibiting a beta crystal form by using an acid paste method.

The first organic liquid used in the process of the present invention may include, but is not limited to, at least one liquid selected from the group consisting of N-methyl-2-pyrrolidone, sulfolane, N,N-dimethyl formamide, glycols such as propylene glycol monomethyl ether acetate, diethylene glycol, alcohols such as diacetone alcohol, acetonitrile, monochlorobenzene, ethylene glycol butyl ether, ketones and quinolines. The first organic liquid may further comprise water.

The second organic liquid used in the process of the present invention may include, but is not limited to, at least one liquid selected from the group consisting of N-methyl-2-pyrrolidone, sulfolane, N,N-dimethyl formamide, diethylene glycol, diacetone alcohol, glycerin, ethylene glycol, propylene glycol, polypropylene glycol, 2-butoxy ethanol, triethylene glycol, diethylene glycol monomethyl ether, triethylene glycol monomethyl ether, dipropylene glycol monomethyl ether, 1-methoxy-2-propanol and 1-ethoxy-2-propanol, ketones and quinolines. The second organic liquid may further comprise water.

The heating step in the process of the present invention may be conducted in the absence of beads at a temperature higher than or equal to 50°C and lower than or equal to 210°C. Alternatively, the heating step may be conducted in the presence of beads at a temperature higher than or equal to 50°C and lower than or equal to 210°C.

The beads used in the process of the present invention may include, but are not limited to, at least one of metallic, plastic, inorganic oxide such as zirconia and glass beads.

It is preferable to further add the particles of copper phthalocyanine substituted by at least one functional group during the heating, acid paste step or kneading, wherein the functional group may be selected from the group consisting of -SO₃M, -SO₂NR₁R₂ and -R₃-NR₄R₅, and wherein: R₁ and R₂ are independent of one another and are hydrogen, alkyl, alkenyl, aryl or cycloalkyl; M is proton, ammonium cation or metal cation; R₃ is a single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N=N-.

Alternatively, the process of the present invention may further comprise the step of dry-blending, wherein the particles of copper phthalocyanine substituted by at least one functional group are further blended with the copper phthalocyanine particles as a dispersion aid after the recovery step c), wherein the functional group may be selected from the group consisting of -SO₃M, -SO₂NR₁R₂ and -R₃-NR₄R₅, and wherein: R₁ and R₂ are independent of one another and are hydrogen, alkyl, alkenyl, aryl or cycloalkyl; M is proton, ammonium cation or metal cation; R₃ is a single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N=N-.

Preferably, the particles of copper phthalocyanine used as a dispersion aid in the present invention may be substituted by the functional group of -SO₃H, -SO₂NHR₁ wherein R₁ is hydrogen, alkyl, alkenyl, aryl, cycloalkyl or

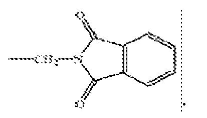

The present invention is also directed to epsilon crystal form copper phthalocyanine particles obtainable according to the process of the present invention. The present invention is further directed to the use of the same in the preparation of color filter pigments.

Further, the present invention is directed to colour filter pigments comprising the epsilon crystal form copper phthalocyanine particles prepared according to the process of the present invention. Also, the present invention is directed to the use of the same in the fabrication of liquid crystal display devices.

### Brief description of drawings

Fig. 1 shows a salt-kneading system used in the process of the present invention.

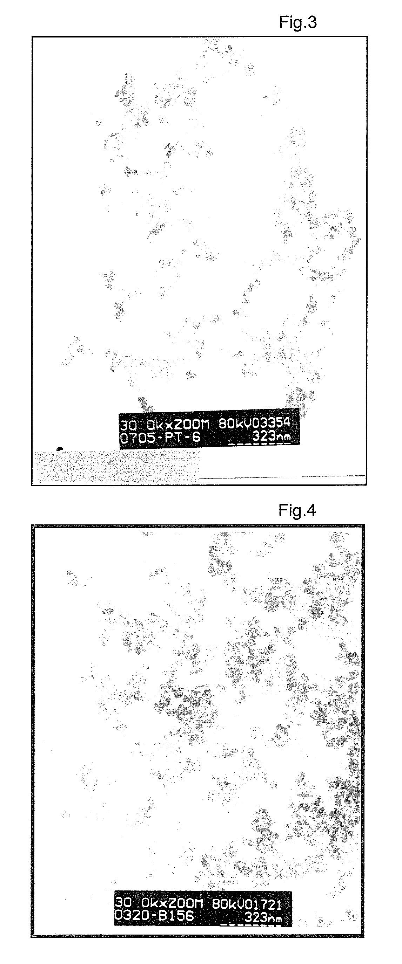

Figs. 2 and 3 show transmission electron micrographs of the epsilon crystal form copper phthalocyanine particles obtained before and after the salt-kneading, respectively, according to the process of the present invention.
Fig. 4 shows a transmission electron micrograph of the epsilon crystal form copper phthalocyanine particles commercially available (purchased from Dainippon Ink & Chemicals Co. located in Japan).

### Examples

### Preparation of epsilon crystal form copper phthalocyanine

1) Crystal phase conversion of copper phthalocyanine from beta crystal form to alpha crystal form
   80 parts by weight of the crude copper phthalocyanine is added to 800 parts by weight of 95 wt % sulfuric acid. Further, the resultant mixture is stirred for 3 hours to prepare a suspension or solution of sulfate in the sulfuric acid. The suspension or the solution is poured to two times 8L of water to obtain an alpha crystal form copper phthalocyanine, which is then dried under hot air. After pulverizing the resulted solid, the alpha crystal form copper phthalocyanine is obtained almost quantitatively in terms of crystallographic yield, which is confirmed by a XRD study.
2) Crystal phase conversion of copper phthalocyanine from alpha crystal form to epsilon crystal form
   60 parts by weight of the obtained alpha crystal form copper phthalocyanine and 12 parts by weight of the epsilon-type copper phthalocyanine are treated at 130°C for 2 hours in 750 parts by weight of N-methyl-2-pyrrolidone. After separating the phase-converted copper phthalocyanine particles by filtration and analyzing with a transmission electron microscope (TEM), copper phthalocyanine particles exhibiting a pure ε crystallographic form are obtained, which is confirmed by a XRD study showing no existence of β crystallographic form.
3) Primary particle size reduction of epsilon crystal form copper phthalocyanine
   To a lab-scale kneader, 50 parts by weight of the obtained copper phthalocyanine particles exhibiting a ε crystallographic form are added with 80 parts by weight of diethylene glycol and 400 parts by weight of sodium chloride. The mixture is kneaded for 12 hours at 80°C with rotation speed of 45 rpm. After kneading, the resultant particles are purified by filtration and dried at temperature of 80°C, pressure of 10⁴ Pa. Upon analyzing the particles with TEM, the obtained copper phthalocyanine particles have smaller primary particle size and better particle shape compared to those of commercially available copper phthalocyanine particles (purchased from Dainippon Ink & Chemicals Co. located in Japan).

## Claims

1. A process of preparing copper phthalocyanine particles exhibiting a ε crystallographic form, comprising a heating step by heating at a temperature higher than or equal to 50°C copper phthalocyanine particles with more than 80 wt % of the particles exhibiting an α crystallographic form and less than 20 wt % of particles exhibiting an ε crystallographic form in the presence of a first organic liquid and optionally milling in the presence of beads.

2. The process of Claim 1, further comprising the following steps :
a) a separation step by separating the copper phthalocyanine particles exhibiting a ε crystallographic form from the first organic liquid and the beads, if used;
b) a kneading step by kneading the copper phthalocyanine particles separated at step a) with at least one inorganic salt and a second organic liquid to obtain the copper phthalocyanine particles having an averaged particle size of less than 30 nm; and
c) a recovery step by recovering the copper phthalocyanine particles by removing the second organic liquid and the inorganic salt.

3. The process of Claim 1 or 2, wherein the copper phthalocyanine particles with more than 80 wt % of the particles exhibiting an α crystallographic form are prepared from copper phthalocyanine particles exhibiting a β crystallographic form by using an acid paste method.

4. The process of any one of Claims 1 to 3, wherein the first organic liquid is at least one liquid selected from the group consisting of N-methyl-2-pyrrolidone, sulfolane, N,N-dimethyl formamide, glycols such as propylene glycol monomethyl ether acetate, diethylene glycol, alcohols such as diacetone alcohol, acetonitrile, monochlorobenzene, ethylene glycol butyl ether, ketones and quinolines.

5. The process of any one of Claims 2 to 4, wherein the second organic liquid is at least one liquid selected from the group consisting ofN-methyl-2-pyrrolidone, sulfolane, N,N-dimethyl formamide, diethylene glycol, diacetone alcohol, glycerin, ethylene glycol, propylene glycol, polypropylene glycol, 2-butoxy ethanol, triethylene glycol, diethylene glycol monomethyl ether, triethylene glycol monomethyl ether, dipropylene glycol monomethyl ether, 1-methoxy-2-propanol, 1-ethoxy-2-propanol, ketones and quinolines.

6. The process of any one of Claims 1 to 5, wherein the heating step is conducted in the absence of beads at a temperature higher than or equal to 50°C and lower than or equal to 210°C.

7. The process of any one of Claims 1 to 5, wherein the heating step is conducted in the presence of beads at a temperature higher than or equal to 50°C and lower than or equal to 210°C.

8. The process of any one of Claims 1 to 5 and 7, wherein the beads are at least one of metallic, plastic, inorganic oxide such as zirconia and glass beads.

9. The process of any one of Claims 1 to 8, wherein particles of copper phthalocyanine substituted by at least one functional group selected from the group consisting of -SO₃M, -SO₂NR₁R₂ and -R₃-NR₄R₅,
wherein R₁ and R₂ are independent of one another and are hydrogen, alkyl, alkenyl, aryl or cycloalkyl; M is proton, ammonium cation or metal cation; R₃ is a single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N=N-,
are further added during the heating, acid paste or kneading step.

10. The process of any one of Claims 2 to 8, further comprising a step of dry-blending wherein particles of copper phthalocyanine substituted by at least one functional group selected from the group consisting of -SO₃M, -SO₂NR₁R₂ and -R₃-NR₄R₅,
wherein R₁ and R₂ are independent of one another and are hydrogen, alkyl, alkenyl, aryl or cycloalkyl; M is proton, ammonium cation or metal cation; R₃ is a single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N=N-,
are further blended with the copper phthalocyanine particles after the recovery step c).

11. The process of Claim 9 or 10, wherein the functional group is -SO₃H, -SO₂NHR₁, wherein R₁ is hydrogen, alkyl, alkenyl, aryl, cycloalkyl, or

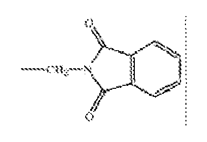

12. Copper phthalocyanine particles obtainable according to the process of any one of Claims 1 to 11.

13. Copper phthalocyanine particles according to claim 12 having an averaged particle size lower than or equal to 30 nm, as measured by a transmission electron microscope.

14. Color filter pigments comprising the copper phthalocyanine particles according to Claim 12 or 13.

15. Use of the copper phthalocyanine particles according to Claim 12 or 13 in the preparation of color filter pigments.

16. Use of the color filter pigments according to Claim 14 in the fabrication of liquid crystal display devices.
